Europäisches Patentamt

European Patent Office

Office européen des brevets

(19)

(11) **EP 1 037 287 A1**

(12) **DEMANDE DE BREVET EUROPEEN**

(43) Date de publication:
**20.09.2000   Bulletin 2000/38**

(51) Int Cl.⁷: **H01L 41/04**

(21) Numéro de dépôt: **00400509.6**

(22) Date de dépôt: **25.02.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **17.03.1999  FR 9903317**

(71) Demandeur: **Renault**
**92100 Boulogne Billancourt (FR)**

(72) Inventeur: **Ballesteros, Guillermo**
**77290 Mitry-Mory (FR)**

(54) **Circuit de commande d'un actionneur piézo-électrique, notamment pour soupape d'injection**

(57)    Ce circuit coopère avec un calculateur de moteur déterminant le cycle d'injection de celui-ci. L'actionneur présente une capacité équivalente (C) dont la charge et la décharge sont assurées à partir d'une source d'alimentation (S), respectivement par des composants semi-conducteurs commandés de charge et de décharge (T1, T2). Ceux-ci sont pilotés par des transitions d'un signal (VCM) apparaissant en début et en fin de chaque cycle d'injection établi par le calculateur.

Selon l'invention, l'un des composants semi-conducteurs (T1) est monté en série avec la capacité (C) et l'autre (T2) lui est connecté en parallèle.

Des chaînes de pilotage (C1, C2) sont raccordées aux électrodes de commande des composants semi-conducteurs (T1, T2) pour leur appliquer des tensions (VgsT1, VgsT2) capables de leur imposer un comportement à variation continue pendant leur transition entre leur état bloqué et leur état de conduction et un comportement par tout ou rien lors de la transition inverse.

FIG.: 2

**Description**

La présente invention est relative à un circuit de commande d'un actionneur piézo-électrique, notamment pour une soupape d'injection d'un moteur à combustion interne.

L'utilisation de tels actionneurs est de plus en plus fréquente par exemple dans les moteurs diesel alimentés en carburant par une rampe commune.

Un actionneur piézo-électrique comporte essentiellement un élément actif en céramique qui est associé mécaniquement à la soupape d'injection qu'elle actionne par sa propre déformation lorsqu'une tension électrique lui est appliquée. Du point de vue électrique, un tel élément actif se comporte comme une capacité. Ainsi, pour l'exciter, il est déjà connu de le coupler à une inductance de manière à former un circuit oscillant. Ce circuit oscillant étant soumis à une tension d'alimentation V, on peut ainsi charger l'élément à une tension 2V en mode oscillant pour le déformer.

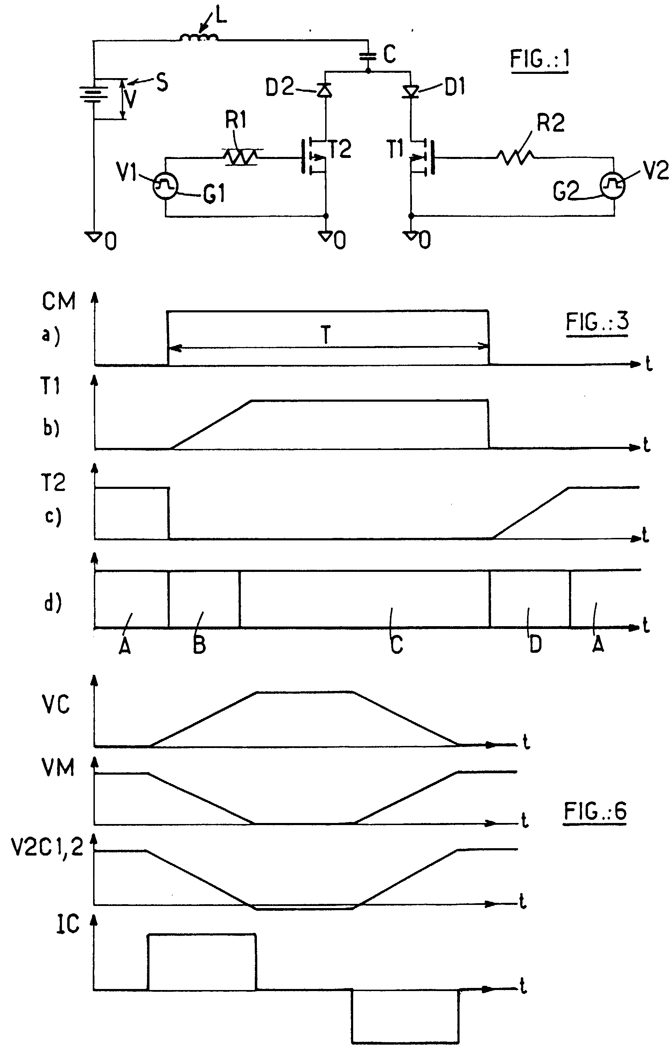

La figure 1 des dessins annexés représente un tel montage connu. On voit que la capacité C de l'élément piézo-électrique en céramique est connectée en série avec une inductance L qui à son tour est reliée à l'une des bornes d'une source de tension S de tension V. L'inductance L et la capacité C sont connectées en série avec deux branches parallèles comportant chacune une diode D1, D2 et un transistor T1, T2, l'une des branches assurant la charge de la capacité C et l'autre sa décharge. Chaque transistor est commandé en régime de tout ou rien par un générateur d'impulsions G1, G2 commandant la grille du transistor associé par l'intermédiaire d'une résistance R1, R2. Les générateurs d'impulsions G1 et G2 fournissent respectivement des impulsions V1 et V2 au rythme des instants d'injection exigés pour le cylindre associé du moteur à combustion interne, sous la commande du calculateur avec lequel ce moteur est équipé.

Lorsque le transistor T1 est commandé en mode passant par le générateur d'impulsions G2, la capacité C de l'élément piézo-électrique se charge en mode oscillant. La tension à ses bornes est sinusoïdale et atteint un maximum égal à 2V. Lorsque ce maximum est atteint, le courant dans la capacité C s'annule, la diode D1 se bloque et le transistor T1 est amené également à se bloquer. La tension sur la capacité reste alors constante.

Lorsque le transistor T2 est rendu conducteur par son générateur d'impulsions G1, la capacité C se décharge sous un mode oscillant également avec un courant et une tension sinusoïdaux qui s'annulent à la fin de la décharge. La diode D2 se bloque et le transistor T2 est amené à se bloquer.

Ce montage connu présente des avantages certains, notamment par le fait que la tension d'alimentation dont il a besoin est la moitié de la tension de charge de la capacité C dans laquelle par ailleurs aucune énergie appréciable n'est dissipée, car l'énergie qui lui est fournie est récupérée à chaque cycle de fonctionnement.

Mais ce montage présente également des inconvénients. Tout d'abord, il nécessite pour le circuit oscillant une inductance qui ne peut pas être intégrée avec les autres composants sur une même pastille semi-conductrice. En outre, cette inductance est encombrante, lourde et coûteuse. En second lieu, la valeur de l'inductance doit être ajustée avec précision à la valeur de la capacité de l'élément piézo-électrique de sorte que le montage ne peut être universellement appliqué à différents types d'actionneurs de soupape. Enfin, comme les transistors de puissance T1 et T2 sont commandés en tout ou rien le courant induit en mode commun est important à chaque commutation. Il en résulte des perturbations électromagnétiques qui peuvent avoir des influences défavorables sur d'autres équipements situés notamment au voisinage des conducteurs électriques. Il faut donc prévoir un filtrage adéquat de ces courants perturbateurs nécessitant d'autres composants inductifs, ce qui augmente encore l'encombrement et le coût de l'ensemble. En résumé, les avantages de ce montage connu n'en compensent pas les inconvénients.

L'invention a pour but de fournir un circuit de commande d'un actionneur piézo-électrique permettant d'éliminer l'utilisation de composants inductifs encombrants et coûteux et de réduire les parasites risquant de perturber l'environnement électromagnétique dans lequel travaille le circuit.

L'invention a donc pour objet un circuit de commande d'un actionneur piézo-électrique, notamment pour soupape d'injection d'un moteur à combustion interne commandé par un calculateur déterminant le cycle d'injection de celui-ci, cet actionneur présentant une capacité électrique équivalente dont, pour exécuter un cycle d'injection, la charge et la décharge sont assurées à partir d'une source d'alimentation, respectivement par un premier composant semi-conducteur commandé de charge et un second composant semi-conducteur commandé de décharge, ces premier et second composants semi-conducteurs étant pilotés respectivement par des transitions d'un signal apparaissant en début et en fin de chaque cycle d'injection établi par ledit calculateur,

caractérisé en ce que ledit premier composant semi-conducteur est monté en série avec ladite capacité sur ladite source de tension,

en ce que ledit second composant semi-conducteur est connecté en parallèle à ladite capacité,

en ce qu'il comporte en outre des première et seconde chaînes de pilotage raccordées respectivement aux électrodes de commande desdits composants semi-conducteurs pour leur appliquer des tensions de commande capables d'imposer auxdits composants semi-conducteurs respectifs un comportement à variation continue pendant leur transition entre leur état bloqué et leur état de conduction et un comportement par tout ou rien lors de la transition inverse.

Grâce à ces caractéristiques, le circuit de commande est dépourvu de toute inductance ce qui conduit à un gain de place et une possibilité d'intégration complète du circuit. En outre, les parasites électromagnétiques engendrés par le circuit et ses conducteurs sont fortement réduits notamment par l'absence de commutations brusques lors des transitions vers l'état de conduction des composants semi-conducteurs.

Par ailleurs, comme les signaux de commande appliqués aux composants semi-conducteurs peuvent être choisis librement par le concepteur, le circuit peut être facilement adapté à tout type d'actionneur piézo-électrique existant sur le marché. Cette souplesse d'adaptation des lois de commande de charge et de décharge de la capacité de l'actionneur piézo-électrique permet également de sélectionner des conditions de fonctionnement du montage qui soient les plus favorables en matière de compatibilité électromagnétique dans l'environnement d'un véhicule automobile dans lequel le circuit selon l'invention est utilisé.

Selon d'autres caractéristiques essentielles de l'invention:

- lesdits composants semi-conducteurs sont des transistors MOS à effet de champ à canal N;
- ladite tension de commande présente une forme telle que lors de la transition entre l'état bloqué et l'état de conduction le comportement de chaque semi-conducteur suit une fonction continûment variable;
- ladite tension de commande présente une forme telle que lors de la transition entre l'état bloqué et l'état de conduction le comportement de chaque composant semi-conducteur suit une fonction affine;
- ladite tension de commande présente une forme telle que lors de la transition entre l'état bloqué et l'état de conduction, le comportement de chaque composant semi-conducteur suit une fonction sinusoïdale;
- chaque chaîne de pilotage comprend un générateur d'une tension de consigne, un comparateur pour comparer cette tension de consigne à une tension de référence prédéterminée et un régulateur proportionnel-intégral qui fournit ladite tension de commande à partir du résultat de la comparaison faite par ledit comparateur respectif;
- ledit générateur de tension de consigne fournit une tension en forme de rampe;
- l'excursion de ladite tension de consigne est légèrement supérieure à la tension de charge de ladite capacité; et
- ladite tension de référence est celle d'un noeud entre les trajets de puissance desdits composants semi-conducteurs.

L'invention a également pour objet un ensemble d'un moteur à combustion interne à injection directe de carburant équipé d'un dispositif de chauffage électrique et d'un circuit de commande tel que défini ci-dessus, caractérisé en ce que ledit circuit de commande est incorporé audit dispositif de chauffage pour récupérer l'énergie thermique qui s'en dégage au cours de son fonctionnement.

D'autres caractéristiques et avantages de l'invention apparaîtront au cours de la description qui va suivre donnée uniquement à titre d'exemple et faite en se référant aux dessins annexés sur lesquels:

- la figure 1 déjà décrite représente un schéma d'un circuit de commande d'un actionneur piézo-électrique de la technique antérieure;
- la figure 2 montre un schéma d'un circuit de commande selon l'invention;
- les figures 3 à 6 sont des diagrammes des temps illustrant le fonctionnement du circuit de commande selon l'invention.

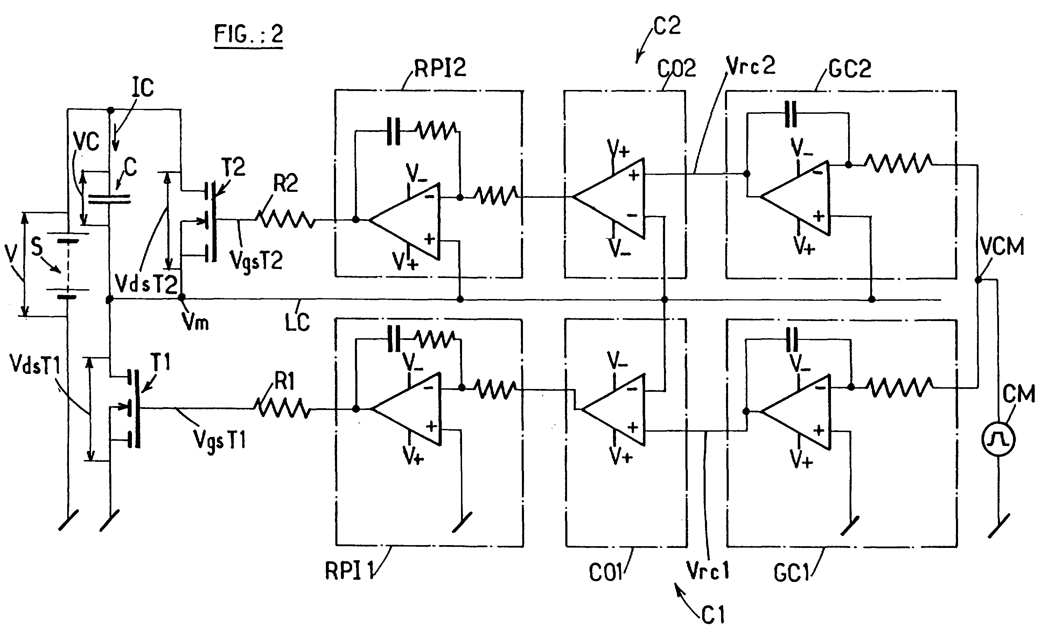

On va maintenant se référer à la figure 2 qui montre un mode de réalisation préféré d'un circuit de commande d'un actionneur piézo-électrique selon l'invention.

La capacité C d'un actionneur piézo-électrique notamment pour soupape d'injection d'un moteur à combustion interne est connectée en série avec un composant semi-conducteur T1 sur les bornes d'une source de tension continue S de tension V.

Un autre composant semi-conducteur T2 est monté en parallèle sur cette même capacité C. Le composant T1 en assure la charge et le composant T2 en assure la décharge. Dans le mode de réalisation préféré de l'invention, les composants semi-conducteurs T1 et T2 sont des transistors MOS à effet de champ MOSFET à canal N. Les grilles de commande de ces transistors sont connectées respectivement à des résistances R1 et R2.

A chaque transistor T1 et T2 est associée une chaîne de pilotage C1, C2 chargée d'engendrer le signal de commande appliqué à la grille du transistor associé par l'intermédiaire de la résistance respective R1, R2. Chaque chaîne de pilotage C1, C2 comporte un générateur de consigne GC1, GC2, un comparateur CO1, CO2 et un régulateur proportionnel-intégral RPI1, RPI2.

Les générateurs de consigne GC1, GC2 sont commandés par des impulsions d'injection provenant d'un calculateur de commande CM du moteur à combustion interne, qui détermine le déclenchement et la durée des impulsions en fonction des instants de début d'injection et de fin d'injection exigés pour le fonctionnement souhaité du moteur à combustion interne.

Le noeud auquel sont raccordés les trajets drain-source des transistors T1 et T2 et la capacité C est connecté à une ligne LC qui est portée à une tension de référence utilisée dans les comparateurs CO1 et C02.

Le fonctionnement du circuit que l'on vient de décrire est le suivant.

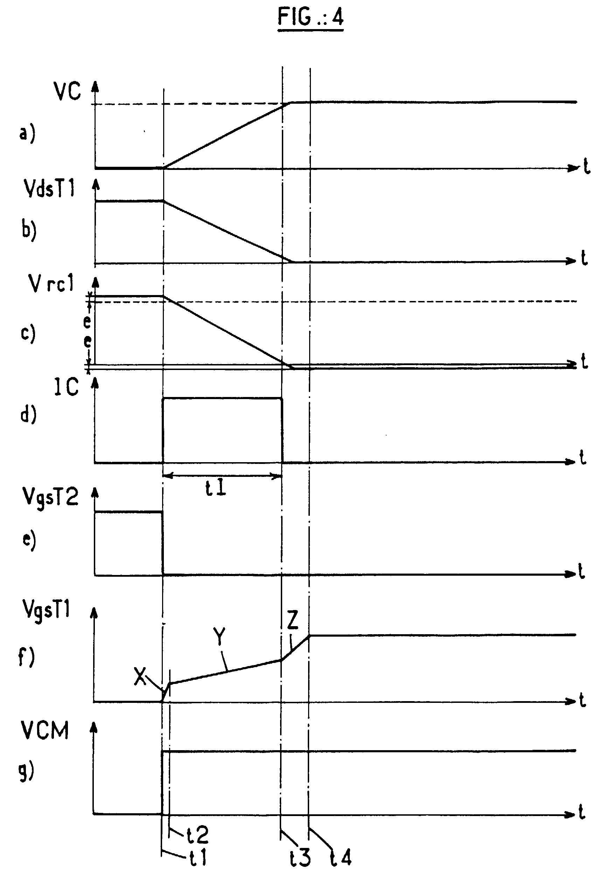

Le circuit peut exécuter quatre séquences de fonctionnement (figure 3d):

- Séquence sans injection A;
- Séquence de charge B de la capacité C de la céramique piézo-électrique;
- Séquence d'injection C;
- Séquence de décharge D de la capacité de la céramique piézo-électrique.

Le calculateur CM du moteur thermique émet un ordre d'injection qui se traduit par un signal logique d'injection d'une durée T (figure 3a), T étant la durée d'injection. Avant l'apparition de l'impulsion d'injection, le transistor T2 est conducteur et le transistor T1 est bloqué (figures 3b et c). Il est important que le transistor T2 reste conducteur en l'absence d'impulsions d'injection pour maintenir la capacité C en court-circuit, sinon des courants parasites pourraient charger la céramique piézo-électrique aléatoirement, ce qui provoquerait alors une injection non désirée.

La commande d'injection issue du calculateur CM répond aux besoins du moteur thermique (quantité de carburant désirée, déphasage avec la position du moteur et des soupapes). L'impulsion est envoyée simultanément aux deux chaînes de pilotage C1, C2 des transistors T1 et T2.

Lorsque le signal d'injection passe du niveau bas au niveau haut, le transistor T2 est immédiatement bloqué (figure 3c), sa commande fonctionne alors en tout ou rien. Par contre, le transistor T1 est piloté en régime linéaire (figure 3b) à partir de cet instant.

Lorsque inversement, le signal d'injection passe du niveau haut au niveau bas, le transistor T1 est immédiatement bloqué et le transistor T2 est amorcé pour fonctionner en régime linéaire.

Par conséquent, selon une caractéristique importante de l'invention, les chaînes de pilotage C1 et C2 assurent un pilotage linéaire des transistors uniquement, lorsque ceux-ci transitent de leur état bloqué vers leur état de conduction, la transition inverse se faisant en tout ou rien lors de la détection de front montant du signal d'injection pour ce qui concerne le transistor T2 et du front descendant pour ce qui concerne le transistor T1.

On va maintenant décrire la séquence de charge de la capacité C en se référant plus particulièrement à la figure 4.

Cette séquence commence au temps t1 lors de la détection du front montant du signal d'injection (figure 4g) émis par le calculateur de commande CM du moteur à combustion interne.

Au cours de cette séquence, le transistor T2 est maintenu bloqué sans passer par le régime linéaire (figure 4e - tension grille-source VgsT2 du transistor T2), et le transistor T1 est passant (figure 4f - tension grille-source VgsT1), et fonctionne en régime linéaire.

Le générateur de rampe GC1 fournit une consigne (figure 4c - tension Vrc1) qui est comparée à la tension drain-source VGST1 du transistor T1. L'erreur de régulation ainsi calculée permet au régulateur RPI1 de fournir la tension de grille VgsT1 qui commande le transistor T1.

Selon une caractéristique avantageuse de l'invention, la consigne Vrcl présente une excursion légèrement supérieure à la tension d'alimentation V de la céramique piézo-électrique C en étant d'abord légèrement supérieure pour aboutir à une valeur légèrement négative afin d'assurer le blocage ou l'amorçage parfait du transistor. Les écarts par rapport à la tension V sont indiquée en e sur la figure 4c.

La tension drain-source VdsT1 du transistor T1 va donc suivre cette consigne en passant progressivement d'un état bloqué (VdsT1 = V) à un état passant (VdsT1 = 0). Par sa tension de grille VgsT1 croît d'abord brièvement selon une pente raide entre le temps t1 et le temps t2 (tronçon x, figure 4f), puis selon une pente linéaire relativement faible jusqu'à l'instant t3 (tronçon y) où la consigne Vrc1 devient négative, puis enfin avec une pente relativement raide jusqu'à l'instant t4 (tronçon z). Le tronçon x est dû à la tension de seuil du transistor T1, tandis que le tronçon z apparaît dès l'instant où la tension Vrc1 devient négative.

La céramique piézo-électrique C sera donc chargée avec un courant de charge IC qui vaut:

$$IC = C\frac{dVC}{dt} = -C\frac{dVdsT1}{dt} \qquad (1)$$

Ainsi, pour une consigne de type fonction affine (cas représenté), le courant de charge IC est constant (figure 4d).

Selon une variante, si la consigne Vrc1 est du type sinusoïdal, le courant de charge sera également sinusoïdal. De façon générale, la consigne peut être d'une forme quelconque ce qui octroie une grande souplesse à ce type de pilotage. La tension VdsT1 varie lentement, ce qui permet une bonne maîtrise des phénomènes parasites.

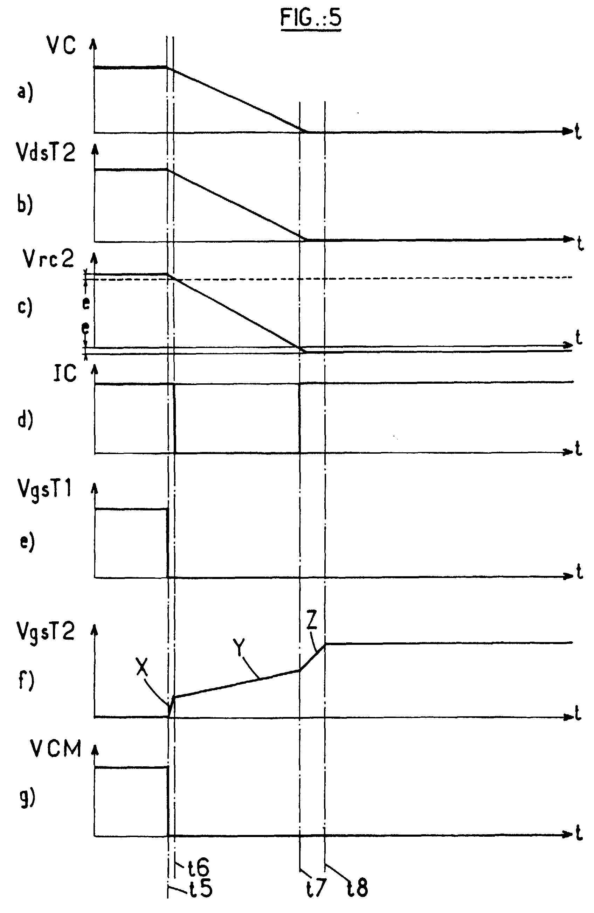

On va maintenant décrire la séquence de décharge de la capacité C en se référant plus particulièrement à la figure 5. Cette séquence se déroule de façon analogue à celle de la séquence de charge, à ceci près que le transistor T2 sera commandé en régime linéaire au lieu du transistor T1, lors de la transition de son état bloqué vers son état conducteur.

Cette séquence commence lors de la détection du front descendant du signal d'injection au temps t5, c'est-à-dire, lorsque la soupape d'injection doit être fermée (figure 5g).

Au cours de cette séquence, le transistor T1 est maintenu bloqué dès l'instant t5 (tension grille-source VgsT1 maintenue à zéro), seul le transistor T2 est passant et subit le régime linéaire pendant la transition entre ses deux états de conduction.

Le générateur de rampe GC2 fournit une consigne Vrc2 qui est comparée à la tension drain-source du transistor T2(VdsT2) par l'intermédiaire de la tension de source du transistor T2 et du comparateur C02. L'erreur de régulation ainsi calculée est transmise au régulateur RPI2. Ce dernier commande la tension grille-source VgsT2 du transistor T2. Dans ce cas également, la consigne part d'une valeur légèrement supérieure à la tension d'alimentation V pour aboutir à une valeur légèrement inférieure à celle-ci (écarts e - figure 5c).

La tension source de T2 va donc suivre cette consigne et permettre ainsi la décharge de la céramique piézo-électrique. Le courant de décharge IC vaut alors :

$$IC = C\frac{dVC}{dt} = C\frac{dVdsT2}{dt} \qquad (2)$$

Il est à noter que piloter la tension drain-source du transistor T2 ou piloter la tension drain-source du transistor T1 revient à piloter la tension de source du transistor T2 ou encore à piloter la tension de drain du transistor T1. En effet, la tension de drain du transistor T1 et la tension de source du transistor T2 se confondent (il s'agit du même noeud). Si on note Vm cette tension, on a :

$$VdsT1 = Vm \qquad (3)$$

et

$$VdsT2 = V-Vm \qquad (4)$$

La tension drain-source du transistor T2 est donc l'opposée de celle du transistor T1 au terme V près, où V est la tension d'alimentation de la céramique piézo-électrique C. Charger celle-ci revient donc à diminuer la tension Vm de V volts à 0 volts. La décharger revient à augmenter la tension Vm de 0 volts à V Volts. Le pilotage linéaire peut donc se faire à partir d'une consigne unique qui asservit la tension Vm. La figure 6 résume ce concept. Il en résulte que on peut à la rigueur se contenter d'un seul générateur de tension de rampe.

En résumé, plutôt que de considérer deux consignes, on peut n'en considérer qu'une seule qui asservit la tension Vm. La consigne doit partir d'une valeur légèrement négative pour assurer la charge complète de la céramique piézo-électrique C (donc la saturation complète du transistor T1), et doit atteindre une valeur légèrement supérieure à la tension V pour en assurer la décharge complète (donc la saturation complète du transistor T2). Quant au blocage des transistors T1 et T2, il se fait respectivement (figure 4g et 5g) sur la détection du front descendant et du front montant du signal de commande émis par le calculateur du moteur à combustion interne.

On notera qu'en dehors de ces deux séquences, il y a deux autres séquences: à savoir une séquence sans injection A et une séquence d'injection C (voir figure 3).

Comme il a déjà été indiqué ci-dessus, quand il n'y a pas d'injection, le transistor T2 est conducteur et le transistor T1 est bloqué pour garantir que la céramique piézo-électrique C ne soit pas chargée par des courants de fuite.

La séquence d'injection A a lieu entre les séquences de charge et de décharge. Pour cela, la tension de la céramique piézo-électrique C doit être maintenue constante. Le transistor T1 reste donc conducteur au cours de cette séquence et le transistor T2 est maintenu bloqué.

Pour fixer les idées et à titre d'exemple uniquement, Vc, VdsT1, Vrc1 et Vrc2 = 120V, VgsT1 et VgsT2 = 15V et IC = 10 A.

L'énergie électrique dissipée par ce montage sous forme de chaleur peut avantageusement être utilisée. En effet, les moteurs à injection directe diesel et essence que l'on équipera de préférence avec un montage selon l'invention ont un bon rendement thermique et nécessitent ainsi un dispositif de chauffage électrique. Ainsi, si le circuit de commande est refroidi à l'eau, il peut se comporter comme une partie intégrante de ce dispositif de chauffage permettant ainsi d'en récupérer l'énergie qui s'en dégage au cours de son fonctionnement.

## Revendications

**1.** Circuit de commande d'un actionneur piézo-électrique, notamment pour soupape d'injection d'un moteur à combustion interne commandé par un calculateur déterminant le cycle d'injection de celui-ci, cet actionneur présentant une capacité électrique équivalente (C) dont, pour exécuter un cycle d'injection, la charge et la décharge sont assurées à partir d'une source d'alimentation (S), respectivement par un premier composant semi-conducteur commandé de charge (T1) et un second composant semi-conducteur commandé de décharge (T2), ces premier et second composants semi-conducteurs étant pilotés respectivement par des transitions d'un signal (VCM) apparaissant en début et en fin de chaque cycle d'injection établi par ledit calculateur,

caractérisé en ce que ledit premier composant semi-conducteur (T1) est monté en série avec ladite capacité (C) sur ladite source de tension (S),

en ce que ledit second composant semi-conducteur (T2) est connecté en parallèle à ladite capacité (C),

en ce qu'il comporte en outre des première et seconde chaînes de pilotage (C1, C2) raccordées respectivement aux électrodes de commande desdits composants semi-conducteurs (T1, T2) pour leur appliquer des tensions de commande (VgsT1, VgsT2) capables d'imposer auxdits composants semi-conducteurs respectifs un comportement à variation continue pendant leur transition entre leur état bloqué et leur état de conduction et un comportement par tout ou rien lors de la transition inverse.

2. Circuit de commande suivant la revendication 1, caractérisé en ce que lesdits composants semi-conducteurs (T1, T2) sont des transistors MOS à effet de champ à canal N.

3. Circuit de commande suivant l'une quelconque des revendications 1 et 2, caractérisé en ce que ladite tension de commande (VgsT1, VgsT2) présente une forme telle que lors de la transition entre l'état bloqué et l'état de conduction le comportement de chaque composant semi-conducteur suit une fonction affine.

4. Circuit de commande suivant l'une quelconque des revendications 1 et 2, caractérisé en ce que ladite tension de commande (VgsT1, VgsT2) présente une forme telle que, lors de la transition entre l'état bloqué et l'état de conduction, le comportement de chaque composant semi-conducteur (T1, T2) suit une fonction continûment variable.

5. Circuit de commande suivant l'une quelconque des revendications 1 et 2, caractérisé en ce que ladite tension de commande (VgsT1, VgsT2) présente une forme telle que, lors de la transition entre l'état bloqué et l'état de conduction, le comportement de chaque composant semi-conducteur (T1, T2) suit une fonction sinusoïdale.

6. Circuit de commande suivant l'une quelconque des revendications 1 à 5, caractérisé en ce que chaque chaîne de pilotage (C1, C2) comprend un générateur (GC1, GC2) d'une tension de consigne (Vrc1, Vrc2), un comparateur (CO1, CO2) pour comparer cette tension de consigne à une tension de référence (Vm) prédéterminée et un régulateur proportionnel-intégral (RPI1, RPI2) qui fournit ladite tension de commande à partir du résultat de la comparaison faite par ledit comparateur respectif (CO1, C02).

7. Circuit de commande suivant la revendication 6, caractérisé en ce que ledit générateur de tension de consigne (GC1, GC2) fournit une tension en forme de rampe.

8. Circuit de commande suivant la revendication 7, caractérisé en ce que l'excursion de ladite tension de consigne est légèrement supérieure à la tension d'alimentation (V) de ladite capacité (C).

9. Circuit de commande suivant l'une quelconque des revendications 6 à 8, caractérisé en ce que ladite tension de référence (Vm) est celle d'un noeud entre les trajets de puissance desdits composants semi-conducteurs (T1, T2).

10. Ensemble d'un moteur à combustion interne à injection directe de carburant équipé d'un dispositif de chauffage électrique et d'un circuit de commande suivant l'une quelconque des revendications 1 à 9 caractérisé en ce que ledit circuit de commande est incorporé audit dispositif de chauffage pour récupérer l'énergie thermique qui s'en dégage au cours de son fonctionnement.

FIG.:1

FIG.:3

FIG.:6

FIG.:2

## FIG .: 4

## FIG.:5

Office européen
des brevets

**RAPPORT DE RECHERCHE EUROPEENNE**

Numéro de la demande

EP 00 40 0509

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | WO 98 43305 A (FREUDENBERG HELLMUT ;EGGER KLAUS (DE); KLUEGL WENDELIN (DE); SCHOE) 1 octobre 1998 (1998-10-01) * page 3; figure 1 * ----- | 1 | H01L41/04 |

DOMAINES TECHNIQUES RECHERCHES (Int.Cl.7)

H01L

Le présent rapport a été établi pour toutes les revendications

| Lieu de la recherche | Date d'achèvement de la recherche | Examinateur |
|---|---|---|
| LA HAYE | 7 juin 2000 | Pelsers, L |

CATEGORIE DES DOCUMENTS CITES

X : particulièrement pertinent à lui seul
Y : particulièrement pertinent en combinaison avec un autre document de la même catégorie
A : arrière–plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 00 40 0509

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

07–06–2000

| Document brevet cité au rapport de recherche | Date de publication | Membre(s) de la famille de brevet(s) | Date de publication |
|---|---|---|---|
| WO 9843305        A | 01–10–1998 | DE    19711903 A<br>CN     1244293 T<br>EP     0968535 A | 24–09–1998<br>09–02–2000<br>05–01–2000 |

EPO FORM P0460

Pour tout renseignement concernant cette annexe : voir Journal Officiel de l'Office européen des brevets, No.12/82